# EUROPEAN PATENT APPLICATION

(11) **EP 1 085 330 A1**
(43) Date of publication of application: **21.03.2001**
(21) Application number: 00118730.1
(22) Date of filing: 30.08.2000
(51) Int. Cl.: G01R 29/08

(54) **Arrangement for detection of switched-on mobile telephones in the passenger compartment of aircrafts**

(30) Priority: 16.09.1999 IT GE990112
(71) Applicant: R.G.M. S.p.A., 16157 Genova (IT)
(72) Inventor: Gregori, Massimiliano, 16157 Genova (IT); Brescia, Giuseppe, 16039 Sestri Levante (IT)
(74) Representative: Porsia, Attilio, Dr.

(57) **Abstract**

Plant for the detection of switched-on mobile telephones in the passenger compartment of aircrafts. Said plant consists of a control unit provided with control indicators and equipped so as to supply the whole plant; a series of individually coded sensor units to be installed along the fuselage in the passenger compartment, associated with a communication bus, each sensor unit being equipped with an adjustable interception range to enable the optimal distribution of the sensors for the rapid location of the transmitting device, and an interconnection bus interconnecting the control unit and all the sensor units.

## Description

It is known that mobile telephones can create interferences which are harmful for aircrafts instruments and therefore represent a potential source of danger. In order to prevent people from using mobile phones - more and more common today - on planes, communications made with the on-board loudspeaker are usually used. Apart from intentional breaches, it may happen that passengers forget to switch their mobiles off.

The main aim of the present invention, therefore, is a plant to be installed on aircrafts for the detection and location of any signals of connection with mobile telephones (DECT, GSM, DUAL BAND, ETACS), since also in-calls can be dangerous because they cause the activation of emissions.

A wide range, a very high probability of detection and a hardly existing possibility of false alarm are made possible thanks to the particular technique used, combining the interception of the (broad-band) primary wave with that of modulation signals which are typical of telephone transmissions.

The detection plant according to the invention consists of:
- A control unit to be installed in the technical areas (steward area), provided with control indicators and equipped so as to supply the whole plant;
- A series of sensor units to be installed under the inner paneling along the fuselage in the passenger compartment. These units, individually coded, are associated with a communication bus supplying each of them also with low-voltage energy. Each sensor unit has an adjustable interception range, so as to enable the optimal distribution of the sensors for the rapid location of the transmitting device.
- The interconnection bus, interconnecting the control unit and all the sensor units.

Further characteristics and advantages of the plant according to the invention will be better apparent from the following detailed description of said invention, carried out with reference to the accompanying drawings, in which:
Figure 1 schematically shows the various components of the plant according to the invention.
Figure 2 is a plan view of a fuselage portion of an aircraft in which the plant of the invention is installed, and
Figure 3 is a cross-sectional view according to line III-III of figure 2.

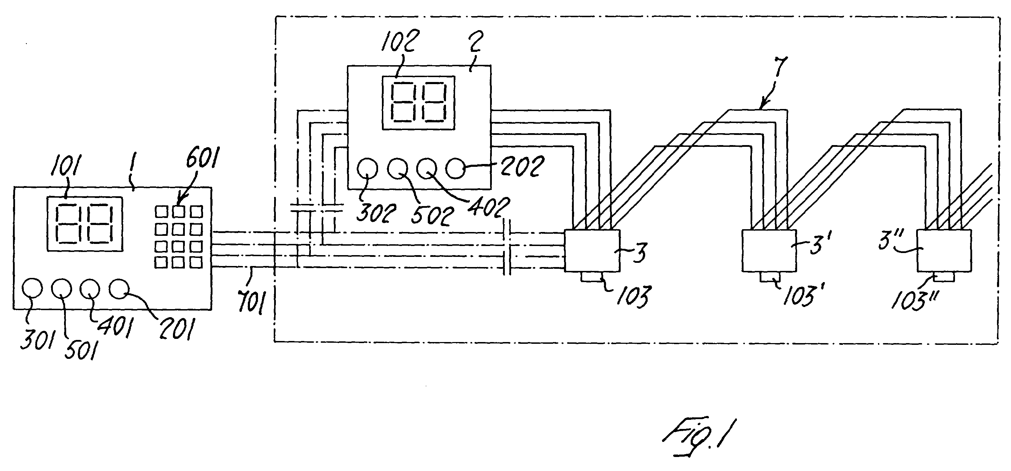

With reference to the drawings, and in particular to figure 1, numeral 1 indicates the programming unit of said plant, numeral 2 indicates the control unit and numeral 3 indicates the sensor unit. The various units shall be interconnected with a cascade connection using the proper interconnection pendants, substantially according to the scheme shown in figure 1.

### DESCRIPTION OF THE UNITS

### A) Programming unit 1

This microprocessor-based unit enables both the programming of the sensor units 3 (code and activation threshold) and the download of the data kept in the storage buffer of the control unit 2. Said unit is battery-supplied, with a pendant terminated onto a connector 701 apt to be alternately connected to units 2 and 3 of the plant.

Its functions are step-controlled following a sequence menu.

Said unit consists of: a 2-digit 7-segment display 101, a main switch 201, a Test/Reset push-button 301, an on-status led 401, and a fault-signaling led 501, beside a twelve-key keyboard.

This unit is alternately connected directly to the sensor units 3, 3' ... etc., and to the control unit 2 during the phases of installation and/or plant check only.

### B) Control unit 2

Said microprocessor-based unit consists of:
a) A plant power supply
b) A control module
c) An interface module

The power supply receives the board-feeding and feeds the plant. A double redundancy input is provided.

The microprocessor-based control module controls the whole plant by continuously monitoring the sensors 3.

The interface module consists of two solid-state relays:
- One of them is kept closed during regular operation
- One of them is closed in case of alarm

A 7-contact connector is available both for operations of programming and downloading of storage data and for the connection to the bus 7, cascade connecting the individual sensor units 3.

As shown, said control unit (2) consists of a main switch 202, a Test/Reset pushbutton 302, a on-status led 402, and an alarm led 502, besides a FIFO memory for the last 50 records of alarm activation.

### C) Sensor unit 3

The unit 3 is based on a tuned circuit which is able to detect telephone modulation signals. A detector with adjustable threshold allows to generate the alarm signal towards the microprocessor each unit is equipped with. Said microprocessor, provided with a rewritable memory, is programmed during the installation with a suitable code (10 to 99) by inputting the desired range value with the keyboard 601 of the programming unit.

The code is used both to identify the unit 3, 3', 3'' ... 3ⁿ and to define the transmission time reserved to test functions.

The set range value acts by selecting the proper threshold value of the detecting circuit.

A led 103, 103' ... 103ⁿ is provided on each unit for local indication.

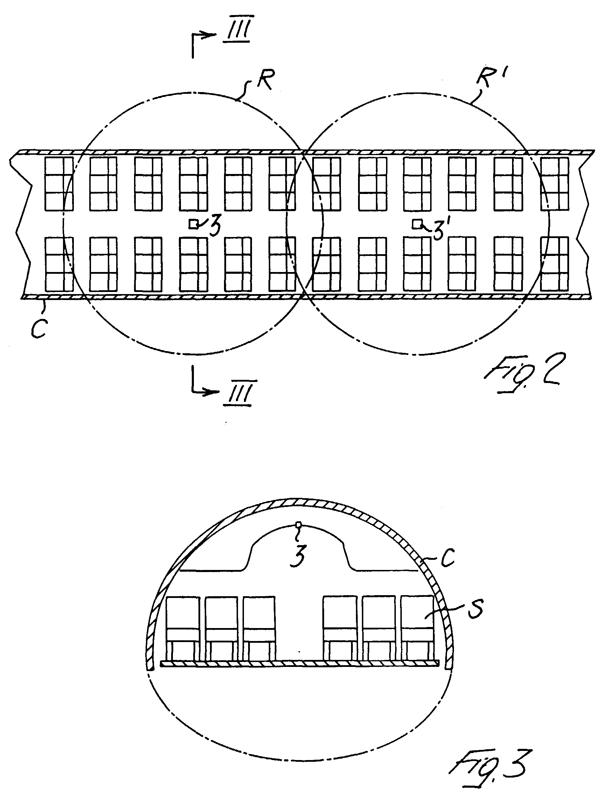

With reference to figures 2 and 3, the mechanical installation of the individual sensor units 3, 3', ... 3ⁿ in the fuselage C of an aircraft will now be disclosed. As shown, said units 3 are installed on the ceiling of the fuselage according to an optimal layout, so as to provide the best covering of the whole fuselage. Each unit 3 should cover a monitoring radius R, R', ... Rⁿ comprising for instance five double rows of seats S. Thanks to the adjustable activation threshold, it is possible to find for each aircraft the best compromise between covering requirements and the need to locate possible emissions. By reducing the activation threshold, though a larger number of sensor units is needed, location will be more effective, since the number of seats from which said mobile signal could come is reduced.

The working of the device previously described will be evident.

In its on-status the control unit 2 feeds all the sensor units 3, which, following the time sequence determined on the basis of the assigned code, indicate regular operation. This indication is displayed both on the control unit (led 402) and on a pair of auxiliary contacts for the signaling to the cockpit.

In case one or more sensor should not respond, the operation fault is signaled by a light (led 502) along with the indication of the non-responding code on the display 102. The operator can thus request a new check (pushbutton 302). The plant is therefore operating (any inactive sensor does not undermine the plant operation).

In case a sensor unit 3 should be activated, it will switch on the local indicating light (led 103) and will communicate the event to the control unit 2. The function of the local light 103 is to enable an immediate location of the area in which an active mobile is present.

An alarm will cause on the control unit 2:
- The lighting of a flashing red light
- The activation of a buzzer
- The indication of the code belonging to the alarm unit
- The closing of a pair of contacts signaling an alarm to the cockpit.

The datum is stored into a buffer organized with a FIFO logic (Date/time and sensor code) and able to keep approximately 50 records which can be recalled with the suitable instrument.

The present invention is obviously not limited to the embodiment here shown and described, but it comprises all those variations and changes within the idea underlying the invention and substantially as later claimed.

## Claims

1. Plant for the detection of switched-on mobile telephones in the passenger compartment of aircrafts, characterized in that it consists of a control unit (2) provided with control indicators (102, 202, 302, 402, 502) and equipped so as to feed the whole plant;
a series of individually coded sensor units (3, 3', 3'' ... 3ⁿ) to be installed along the fuselage in the passenger compartment, each sensor unit (3) being equipped with an adjustable interception range to enable the optimal distribution of the sensors (3, 3' ... 3ⁿ) for the rapid location of the transmitting device; and an interconnection bus (7) interconnecting the control unit (2) to all the sensor units (3).

2. Plant according to claim 1, further comprising a programming unit (1) for the programming of the sensor units (3).

3. Plant according to the preceding claims, in which the various units are interconnected with a cascade connection.

4. Plant according to claim 1, in which said control unit (2) consists of a plant power supply, a control module and an interface module.

5. Plant according to claim 4, in which said interface module consists of two solid-state relays, one of which is kept closed during regular operation, whereas the other is closed in case of alarm.

6. Plant according to claim 1, in which said sensor unit (3) consists of a microprocessor provided with a rewritable memory, and of a detector with adjustable threshold generating the alarm signal towards the microprocessor.

7. Plant according to claim 6, in which said microprocessor is programmed during installation with a suitable code and provided with the desired range value by means of the programming unit.

8. Plant according to claims 6 and 7, in which said sensor units (3) are provided with an optical light (103).

9. Plant according to any of the preceding claims, in which said sensor units (3) are installed on the ceiling of the aircraft fuselage according to an optimal layout, so as to provide the best covering for the whole fuselage.

10. Plant according to any of the preceding claims, in which the reception of an alarm activates a warning light and/or an acoustic signal with the simultaneous display of the code related to the alarmed unit.
